(19) Europäisches Patentamt
European Patent Office
Office européen des brevets

(11) EP 1 671 989 B1

(12) EUROPÄISCHE PATENTSCHRIFT

(45) Veröffentlichungstag und Bekanntmachung des Hinweises auf die Patenterteilung:
**20.10.2010 Patentblatt 2010/42**

(51) Int Cl.:
***C08G 18/08*** *(2006.01)* ***C08G 18/66*** *(2006.01)*
***C08G 18/38*** *(2006.01)* ***B32B 17/10*** *(2006.01)*

(21) Anmeldenummer: **05026321.9**

(22) Anmeldetag: **02.12.2005**

# (54) Thermoplastische Polyurethane und deren Verwendung

Thermoplastic polyurethanes and their use

Polyuréthanes thermoplastiques et leur utilisation

(84) Benannte Vertragsstaaten:
**BE DE ES FR GB IT**

(30) Priorität: **17.12.2004 DE 102004060799**

(43) Veröffentlichungstag der Anmeldung:
**21.06.2006 Patentblatt 2006/25**

(73) Patentinhaber: **Bayer MaterialScience AG**
**51368 Leverkusen (DE)**

(72) Erfinder:
- **Peerlings, Henricus Dr.**
**42699 Solingen (DE)**
- **Kaufhold, Wolfgang Dr.**
**51061 Köln (DE)**
- **Stollwerck, Gunther Dr.**
**47800 Krefeld (DE)**
- **van Mullekom, Robert Hubertus, Dr.**
**9160 Lokeren (NL)**

(56) Entgegenhaltungen:
**EP-A- 0 845 816** **DE-A1- 3 101 457**
**DE-U1- 20 220 444** **JP-A- 8 143 706**
**US-A- 6 084 702**

EP 1 671 989 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die vorliegende Erfindung betrifft thermoplastische Polyurethane mit guter Haftung zum Glas und deren Verwendung.

Thermoplastische Polyurethane (TPU) sind wegen ihrer guten Elastomereigenschaften und thermoplastischen Verarbeitbarkeit von großer technischer Bedeutung. Eine Übersicht über die Herstellung, Eigenschaften und Anwendungen von TPU ist z.B. im Kunststoff Handbuch [G. Becker, D. Braun], Band 7 "Polyurethane", München, Wien, Carl Hanser Verlag, 1983 gegeben.

TPU werden zumeist aus linearen Polyolen (Makrodiolen), wie Polyester-, Polyether- oder Polycarbonatdiolen, organischen Diisocyanaten und kurzkettigen, zumeist difunktionellen Alkoholen (Kettenverlängerern) aufgebaut. Sie können kontinuierlich oder diskontinuierlich hergestellt werden. Die bekanntesten Herstellverfahren sind das Bandverfahren (GB-A 1 057 018) und das Extruderverfahren (DE-A 19 64 834).

Der Aufbau der thermoplastisch verarbeitbaren Polyurethanelastomere kann entweder schrittweise (Prepolymerdosierverfahren) oder durch die gleichzeitige Reaktion aller Komponente in einer Stufe (one-shot-Dosierverfahren) erfolgen.

Bei der Verwendung von thermoplastischem Polyurethan in einem Verbund mit Glas tritt das Problem der Haftung auf. Aus diesem Grund werden daher oft Silane verwendet, um die Haftung zum Glas zu verbessern.

In US 4 718 956 wird ein Octadecyltriethoxysilan beschrieben und für eine vorübergehende Haftung zum Glas eingesetzt.

In WO 2004/054113 wird die Verwendung bifunktioneller, einbaufähiger Silane in TPU beschrieben.

Oft werden Silane auch auf TPU gepropft, wie z.B. in WO 00/75213 oder S. Dassin et al., Polymer Eng. Sci., 2002, 42(8), 1724-1739 beschrieben.

Durch Pfropfen von Silanen auf TPU oder durch Verwendung der einbaufähigen Silanen verändern sich jedoch auch die Extrusionseigenschaften und Materialeigenschaften des TPU nachteilig.

DE 31 01 457 A1 offenbart in der Tabelle 1, Beispiel 3 eine Zusammensetzung, die ein aliphatisches thermoplastisches Polyurethan, ein Aminosilan und 2,9 Gwt.-% eines ureidofunktionellen Silans (Formel Seite 11) beinhaltet.

Aufgabe der vorliegenden Erfindung war es daher, TPUs zur Verfügung zu stellen, welche eine gute Haftung zum Glas haben (auch nach Lagerung/Bewitterung), gleichzeitig eine gute Extrusionsqualität aufweisen und außerdem bei Lagerung oder Bewitterung nicht vergilben.

Diese Aufgabe konnte durch den Einsatz spezieller Silane gelöst werden.

Gegenstand der vorliegenden Erfindung sind daher thermoplastische Polyurethane erhältlich durch Umsetzung eines Gewisches bestehend aus

a) einer oder mehreren organischen Diisocyanatkomponenten,

b) mindestens einer Komponente mit einem zahlenmittleren Molekulargewicht von 450 bis 10.000 g/mol und mit im Mittel mindestens 1,8 bis höchstens 3,0 Zerewitinoff-aktiven Wasserstoffatomen,

c) einem oder mehreren Kettenverlängerern mit einem Molekulargewicht von 60 bis 400 g/mol und mit im Mittel 1,8 bis 3,0 Zerewitinoff-aktiven Wasserstoffatomen,
wobei das molare Verhältnis der Isocyanatgruppen aus a) zu den gegenüber Isocyanat reaktiven Gruppen aus b), c) und gegebenenfalls h) 0,9:1 bis 1,1:1 beträgt,
in Gegenwart von

d) 0,05 bis 5 Gew-.%, bezogen auf thermoplastisches Polyurethan, mindestens eines Silans mit der allgemeinen Strukturformel I

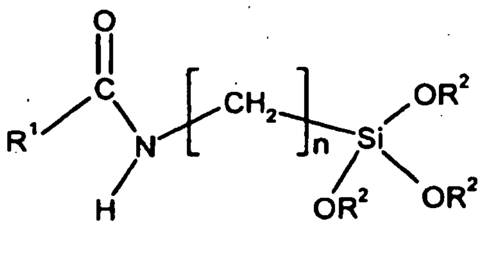

(I)

wobei

n = 1 bis 12 bedeutet
$R^1$ = $NHR^3$ mit $R^3$ = H, Alkyl-, Aryl- oder Aralkylgruppe mit 1 bis 20 Kohlenstoffatomen oder $OR^4$ mit $R^4$ = H, Alkyl-, Aryl- oder Aralkylgruppe mit 1 bis 20 Kohlenstoffatomen,
$R^2$= Alkyl-, Aryl- oder Aralkylgruppe mit 1 bis 20 Kohlenstoffatomen,

e) gegebenenfalls Katalysatoren unter Zusatz von

f) 0,1 bis 10 Gew.-%, bezogen auf thermoplastisches Polyurethan, Lichtstabilisatoren,

g) gegebenenfalls Zusatzmitteln und/oder Hilfsstoffen,

h) gegebenenfalls Kettenabbrechern, wobei d) während der Herstellung des thermoplastischen Polyurethane oder in einem zusätzlichen Verfahrensschritt oder beim Kompoundieren oder bei der Extrusion, dem thermoplastischen Polyurethan zugegeben wird.

Als organische Diisocyanate a) kommen beispielsweise aliphatische, cycloaliphatische, araliphatische, heterocyclische und aromatische Diisocyanate in Betracht, wie sie z.B. in Justus Liebigs Annalen der Chemie, 562, Seiten 75 bis 136, beschrieben werden.

Im Einzelnen seien beispielhaft genannt: aliphatische Diisocyanate, wie Ethylendiisocyanat, 1,4-Tetramethylendiisocyanat, 1,12-Dodecandiisocyanat, 1,6-Hexamethylendiisocyanat, cycloaliphatische Diisocyanate, wie Isophorondiisocyanat, 1,4-Cyclohexan-diisocyanat, 1-Methyl-2,4- und 2,6-cyclohexan-diisocyanat sowie die entsprechenden Isomerengemische, 4,4'-, 2,4'- und 2,2'-Dicyclohexylmethan-düsocyanat sowie die entsprechenden Isomerengemische und aromatische Diisocyanate, wie, 2,4'-Toluylendiisocyanat, Gemische aus 2,4- und 2,6-Toluyiendiisocyanat, 4,4'-Diphenylmethandiisocyanat, 2,4-Diphenylmethandiisocyanat und 2,2'-Diphenylmethandiisocyanat, Gemische aus 2,4'-Diphenylmethandiisocyanat und 4,4'-Diphenylmethandiisocyanat, urethanmodifizierte flüssige 4,4'-Diphenylmethandiisocyanate und/oder 2,4'-Diphenylmethandiisocyanate, 4,4'-Diisocyanatodiphenyl-ethan-(1,2) und 1,5-Naphthylendiisocyanat. Vorzugsweise werden aliphatische und/oder cycloaliphatische Diisocyanate eingesetzt.

Besonders bevorzugt verwendet werden 1,4-Cyclohexandiisocyanat, 1,6-Hexamethylendiisocyanat, Isophorondiisocyanat und Dicyclohexylmethandiisocyanat. Die genannten Diisocyanate können einzeln oder in Form von Mischungen untereinander zur Anwendung kommen. Sie können auch zusammen mit bis zu 15 mol-% (berechnet auf Gesamt-Diisocyanat) eines Polyisocyanates verwendet werden; es darf aber höchstens soviel Polyisocyanat zugesetzt werden, dass ein noch thermoplastisch verarbeitbares Produkt entsteht.

Die Kettenverlängerungsmittel c) besitzen im Mittel 1,8 bis 3,0 zerewitinoffaktive Wasserstoffatome und haben ein Molekulargewicht von 60 bis 400. Hierunter versteht man neben Aminogruppen, Thiolgruppen oder Carboxylgruppen aufweisenden Verbindungen bevorzugt mit zwei bis drei, bevorzugt zwei Hydroxylgruppen.

Als Kettenverlängerer c) wird vorzugsweise eine Verbindung oder mehrere Verbindungen eingesetzt aus der Gruppe der aliphatischen Diole mit 2 bis 14 Kohlenstoffatomen, wie z.B. Ethandiol, 1,2-Propandiol, 1,3-Propandiol, 1,4-Butandiol, 2,3-Butandiol, 1,5-Pentandiol, 1,6-Hexandiol, Diethylenglykol, Dipropylenglykol, 1,4-Cyclohexandiol, 1,4-Dimethanolcyclohexan und Neopentylglykol. Geeignet sind jedoch auch Diester der Terephthalsäure mit Glykolen mit 2 bis 4 Kohlenstoffatomen, z.B. Terephthalsäure-bis-ethylenglykol und Terephthalsäure-bis-1,4-butandiol, Hydroxyalkylenether des Hydrochinons, z.B. 1,4-Di(β-hydroxyethyl)-hydrochinon, ethoxylierte Bisphenole, z.B. 1,4-Di(β-hydroxyethyl)-bisphenol A, (cyclo)aliphatische Diamine, wie Isophorondiamin, Ethylendiamin, 1,2-Propylendiamin, 1,3-Propylendiamin, N-Methyl-propylen-1,3-diamin, N,N'-Dimethylethylendiamin, aromatische Diamine, wie 2,4-Toluylendiamin, 2,6-Toluylendiamin, 3,5-Diethyl-2,4-toluylendiamin und 3,5-Diethyl-2,6-toluylendiamin und primäre mono-, di-, tri- oder tetraalkylsubstituierte 4,4'-Diaminodiphenylmethane. Besonders bevorzugt werden als Kettenverlängerer Ethandiol, 1,4-Butandiol, 1,6-Hexandiol, 1,4-Di(β-hydroxyethyl)-hydrochinon oder 1,4-Di(β-hydroxyethyl)-bisphenol A verwendet. Daneben können auch kleinere Mengen an Triolen zugesetzt werden.

Als Komponente b) werden solche mit im Mittel mindestens 1,8 bis höchstens 3,0 zerewitinoff-aktiven Wasserstoffatomen eingesetzt. Neben Aminogruppen, Thiolgruppen oder Carboxylgruppen aufweisenden Verbindungen werden insbesondere zwei bis drei, bevorzugt zwei Hydroxylgruppen aufweisende Verbindungen verwendet, bevorzugt solche mit zahlenmittleren Molekulargewichten $\overline{M}_n$ von 450 bis 6000, besonders bevorzugt solche mit zahlenmittleren Molekulargewichtem $\overline{M}_n$ von 600 bis 4500; z.B. Hydroxylgruppen aufweisende Polyester, Polyether und Polycarbonate sowie Polyesteramide oder Gemische aus diesen.

Geeignete Polyether-Diole können dadurch hergestellt werden, dass man ein oder mehrere Alkylenoxide mit 2 bis 4 Kohlenstoffatomen im Alkylenrest mit einem Startermolekül, das zwei aktive Wasserstoffatome gebunden enthält, umsetzt. Als Alkylenoxide seien z.B. genannt: Ethylenoxid, 1,2-Propylenoxid, Epichlorhydrin und 1,2- Butylenoxid und 2,3-Butylenoxid. Vorzugsweise Anwendung finden Ethylenoxid, Propylenoxid und Mischungen aus 1,2-Propylenoxid und Ethylenoxid. Die Alkylenoxide können einzeln, alternierend nacheinander oder als Mischungen verwendet werden.

Als Startermoleküle kommen beispielsweise in Betracht: Wasser, Aminoalkohole, wie N-Alkyl-diethanolamine, beispielsweise N-Methyl-diethanolamin und Diole wie Ethylenglykol, 1,3-Propylenglykol, 1,4-Butandiol und 1,6-Hexandiol. Gegebenenfalls können auch Mischungen von Startermolekülen eingesetzt werden. Geeignete Polyetherole sind ferner die hydroxylgruppenhaltigen Polymerisationsprodukte des Tetrahydrofurans. Es können auch trifunktionelle Polyether in Anteilen von 0 bis 30 Gew.-% bezogen auf die bifunktionellen Polyether eingesetzt werden, jedoch höchstens in solcher Menge, dass ein noch thermoplastisch verarbeitbares Produkt entsteht. Die im wesentlichen linearen Polyether-Diole besitzen vorzugsweise zahlenmittlere Molekulargewichte $\overline{M}_n$ von 450 bis 6000. Sie können sowohl einzeln als auch in Form von Mischungen untereinander zur Anwendung kommen.

Geeignete Polyester-Diole können beispielsweise aus Dicarbonsäuren mit 2 bis 12 Kohlenstoffatomen, vorzugsweise 4 bis 6 Kohlenstoffatomen, und mehrwertigen Alkoholen hergestellt werden. Als Dicarbonsäuren kommen beispielsweise in Betracht: aliphatische Dicarbonsäuren wie Bernsteinsäure, Glutarsäure, Adipinsäure, Korksäure, Azelainsäure und Sebacinsäure, oder aromatische Dicarbonsäuren, wie Phthalsäure, Isophthalsäure und Terephthalsäure. Die Dicarbonsäuren können einzeln oder als Gemische, z.B. in Form einer Bernstein-, Glutar- und Adipinsäuremischung, verwendet werden. Zur Herstellung der Polyester-Diole kann es gegebenenfalls vorteilhaft sein, anstelle der Dicarbonsäuren die entsprechenden Dicarbonsäurederivate, wie Carbonsäurediester mit 1 bis 4 Kohlenstoffatomen im Alkoholrest, Carbonsäureanhydride oder Carbonsäurechloride zu verwenden. Beispiele für mehrwertige Alkohole sind Glykole mit 2 bis 10, vorzugsweise 2 bis 6 Kohlenstoffatomen, z:B. Ethylenglykol, Diethylenglykol, 1,4-Butandiol, 1,5-Pentandiol, 1,6-Hexandiol, 1,10-Decandiol, 2,2-Dimethyl-1,3-propandiol, 1,3-Propandiol oder Dipropylenglykol. Je nach den gewünschten Eigenschaften können die mehrwertigen Alkohole allein oder in Mischung untereinander verwendet werden. Geeignet sind ferner Ester der Kohlensäure mit den genannten Diolen, insbesondere solchen mit 4 bis 6 Kohlenstoffatomen, wie 1,4-Butandiol oder 1,6-Hexandiol, Kondensationsprodukte von ω-Hydroxycarbonsäuren wie ω-Hydroxycapronsäure oder Polymerisationsprodukte von Lactonen, z.B. gegebenenfalls substituierten ω-Caprolactonen. Als Polyester-Diole vorzugsweise verwendet werden Ethandiol-polyadipate, 1,4-Butandiolpolyadipate, Ethandiol-1,4-butandiolpolyadipate, 1,6-Hexandiol-neopentylglykolpolyadipate, 1,6-Hexandiol-1,4-butandiolpolyadipate und Polycaprolactone. Die Polyester-Diole besitzen zahlenmittlere Molekulargewichte $\overline{M}_n$ von 450 bis 10000 und können einzeln oder in Form von Mischungen untereinander zur Anwendung kommen.

Gegenüber Isocyanaten monofunktionelle Verbindungen können bevorzugt in Anteilen bis zu 2 Gew.-%, bezogen auf TPU, als sogenannte Kettenabbrecher h) eingesetzt werden. Geeignet sind z.B. Monoamine wie Butyl- und Dibutylamin, Octylamin, Stearylamin, N-Methylstearylamin, Pyrrolidin, Piperidin oder Cyclohexylamin, Monoalkohole wie Butanol, 2-Ethylhexanol, Octanol, Dodecanol, Stearylalkohol, die verschiedenen Amylalkohole, Cyclohexanol und Ethylenglykolmonomethylether.

Die relativen Mengen der Zerewitinoff-aktiven Verbindungen werden bevorzugt so gewählt, dass das Verhältnis der Summe der Isocyanatgruppen zu der Summe der Zerewitinoff-aktiven Wasserstoffatome 0,9:1 bis 1,1:1 beträgt.

Die erfindungsgemäßen, thermoplastischen Polyurethanelastomere können bis zu 10 Gew.-%, bezogen auf die Gesamtmenge an TPU, der üblichen Hilfs- und Zusatzstoffe g) enthalten. Typische Hilfs- und Zusatzstoffe sind Gleitmittel und Entformungsmittel, wie Fettsäureester, deren Metallseifen, Fettsäureamide, Fettsäureesteramide und Siliconverbindungen, Weichmacher, Antiblockmittel, Inhibitoren, Stabilisatoren gegen Hydrolyse, Hitze und Verfärbung, Farbstoffe, Pigmente, anorganische und/oder organische Füllstoffe, fungistatisch und bakteriostatisch wirkende Substanzen sowie Füllstoffe und deren Mischungen.

Nähere Angaben über die genannten Hilfs- und Zusatzstoffe sind der Fachliteratur, beispielsweise der Monographie von J.H. Saunders und K.C. Frisch "High Polymers", Band XVI, Polyurethane, Teil 1 und 2, Verlag Interscience Publishers 1962 bzw. 1964 , dem Taschenbuch für Kunststoff-Additive von R.Gächter u. H.Müller (Hanser Verlag München 1990) oder der DE-A 29 01 774 zu entnehmen.

Als Lichtstabilisatoren f) werden bevorzugt UV-Stabilisatoren, Antioxidantien und/oder HALS-Verbindungen eingesetzt. Nähere Angaben sind der Fachliteratur zu entnehmen und beispielsweise in H. Zweifel, Plastics Additives Handbook, 2001, 5th Ed., Carl Hanser Verlag, München beschrieben.

Die Silane d) oder deren Gemische, welche in einer Menge von 0,05 bis 5 Gew.-%; bezogen auf die Gesamtmenge TPU, zum Einsatz kommen, lassen sich anhand der folgenden Strukturformel beschreiben:

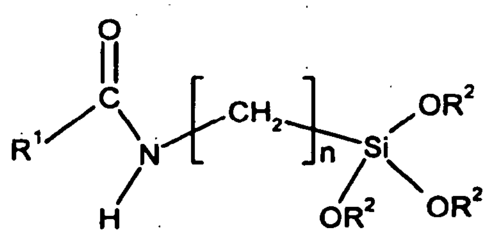

(I)

wobei

n = 1 bis 12 bedeutet

$R^1$ = $NHR^3$ mit $R^3$ = H, Alkyl-, Aryl- oder Aralkylgruppe mit 1 bis 20 Kohlenstoffatomen oder $OR^4$ mit $R^4$= H, Alkyl-, Aryl- oder Aralkylgruppe mit 1 bis 20 Kohlenstoffatomen,

$R^2$ = Alkyl-, Aryl- oder Aralkylgruppe mit 1 bis 20 Kohlenstoffatomen.

Beispielhaft seien als Komponenten d) genannt: Silquest A 1524 der Firma GE Toshiba Silicones (ein Silan mit $R^1$ = $NH_2$, $R^2$ = $CH_3$ und n = 3).

Das Silan kann sowohl während der Herstellung des TPU als auch in einem zusätzlichen Verfahrensschritt sowie beim Kompoundieren oder bei der Extrusion dem TPU zugegeben werden.

Weitere Zusätze, die in das TPU eingearbeitet werden können, sind Thermoplaste, beispielsweise Polycarbonate und Acrylnitril/Butadien/Styrol(ABS)-Terpolymere, insbesondere ABS. Auch andere Elastomere wie Kautschuk, Ethylen/Vinylacetatcopolymere, Styrol/Butadiencopolymere sowie andere TPU können verwendet werden.

Geeignete Katalysatoren e) sind die nach dem Stand der Technik bekannten und üblichen tertiären Amine, wie z.B. Triethylamin, Dimethylcyclohexylamin, N-Methylmorpholin, N,N'-Dimethyl-piperazin, 2-(Dimethylamino-ethoxy) ethanol, Diazabicyclo[2,2,2]octan und ähnliche sowie insbesondere organische Metallverbindungen wie Titansäureester, Eisenverbindungen oder Zinnverbindungen wie Zinndiacetat, Zinndioctoat, Zinndilaurat oder die Zinndialkylsalze aliphatischer Carbonsäuren wie Dibutylzinndiacetat oder Dibutylzinndilaurat oder ähnliche. Bevorzugte Katalysatoren sind organische Metallverbindungen, insbesondere Titansäureester, Eisen-, Zinn-, Zirkon- und Bismuthverbindungen. Die Gesamtmenge an Katalysatoren in den erfindungsgemäßen TPU beträgt vorzugsweise 0 bis 5 Gew.-%, bevorzugt 0 bis 2 Gew.-%, bezogen auf die Gesamtmenge an TPU.

Die Zugabe der Hilfs- und Zusatzstoffe kann während des Herstellprozesses und/oder bei einer zusätzlichen Kompoundierung einem Extrusionsprozess dem TPU eingemischt werden.

Die erfindungsgemäßen thermoplastischen Polyurethane werden zur Herstellung von Verbunden mit Glas, insbesondere zur Herstellung von Solarzellenmodulen eingesetzt.

Zur Herstellung der Verbunde mit Glas wird eine Platte oder ein Film aus den erfindungsgemäßen thermoplastischen Polyurethanen auf eine Glasplatte gelegt und erhitzt, wobei sich der Verbund bildet.

Die Erfindung soll anhand der nachfolgenden Beispiele näher erläutert werden.

Im folgenden verwendete Abkürzungen:

| | |
|---|---|
| Desmophen® 2028 | Polyesterdiol mit einem Molekulargewicht von $M_n$ = 2000 g/mol; Produkt der von Bayer MaterialSciene AG |
| HDI | 1,6-Hexamethylendiisocyanat |
| HDO | 1,6-Hexandiol |
| BDO | 1,4-Butandiol |
| Irganox 1010 | Antioxidant der Firma Ciba Specialty Chemicals GmbH |
| Tinuvin 328 | Licht-Stabilisator auf Basis eines Benzotriazoles der Firma Ciba Specialty Chemicals GmbH |
| DBTL | Dibutylzinndilaurat |
| Silquest A-1100 | 3-Aminopropyltriethoxysilan; Produkt der Firma GE Toshiba Silicones |
| Silquest A-137 | Octyltriethoxysilan; Produkt der Firma GE Toshiba Silicones |
| Silquest Y-11597 | Tris-(3-(trimethoxysilyl)propyl) Isocyanurate; Produkt der Firma GE Toshiba Silicones |
| Silquest A-1524 | Ureidopropyltrimethoxysilan; Produkt der Firma GE Toshiba Silicones |

## Beispiele

### Herstellung des TPU/der Platte

Ein Gemisch aus 1075 g Desmophen®2028, 109 g HDO, 13,5 g BDO, 0,5 Gew.-%, bezogen auf TPU, Irganox 1010 und etwa 60 ppm DBTL (bezogen auf die Polyolmenge) wurde unter Rühren mit einem Flügelrührer mit einer Drehzahl von 500 Umdrehungen pro Minute (UpM) auf 130°C hochgeheizt, wonach 271 g HDI zugegeben wurde. Anschließend wurde bis zum maximal möglichen Viskositätsanstieg gerührt, und dann das TPU ausgegossen. Zum Schluss wurde das Material 30-min bei 80°C thermisch nachbehandelt und anschließend granuliert. Dann wurde das entsprechende Silan (siehe Tabelle) durch Auftrommeln auf das Granulat zugegeben und Spritzgießplatten mit einer Dicke von 2 mm hergestellt.

**Herstellung des Solarmoduls**

Zuerst wurde auf eine eisenarme Weissglasscheibe mit einer Dicke von 4 mm und Abmessungen von 12x12 cm die oben hergestellte TPU-Platte gelegt. Darauf wurde dann eine Solarzelle aus monokristallinem Silizium und darauf wieder eine TPU-Platte und zum Schluss eine Polyvinylfluorid-Folie (Tedlar Icosolar 2442 der Firma Isovolta AG) mit einer Dicke von 180 $\mu$m gelegt. Dieses Modul wurde mit der Glasplatte nach unten in einen Vakuumlaminator gelegt und auf 155°C hochgeheizt. Dann wurde 5 Minuten evakuiert und 6 Minuten gepresst.

**Damp heat Test**

Der Damp heat Test wurde an den hergestellten Solarmodulen gemäß der Norm IEC 61215 durchgeführt, mit dem Unterschied, dass bei 80°C statt bei 85°C gemessen wurde. Nach bestimmten Zeitabschnitten wurde qualitativ bestimmt, ob die Haftung noch vorhanden war, ob sich das Material vergilbt hatte und ob ein Abbau des TPUs stattgefunden hatte (anhand der Messung der Lösungsviskosität).

**Bestimmung der Lösungsviskosität**

99,7 g N-Methyl-2-Pyrrolidon wurden mit 0,1 Gew.% Dibutylamin und 0,4 g TPU eingewogen. Die Proben wurden auf einem Magnetrührer gerührt.
Die Proben wurden bei ca. 70°C ca. 1 Stunde gelöst und über Nacht bei Raumtemperatur stehen gelassen.
Die Proben und eine Blindprobe (reines Lösungsmittel) wurden bei 25°C an einem Viskositätsmessplatz der Fa. Schott gemessen.
Die relative Lösungsviskosität ist das Verhältnis der Viskosität der jeweiligen Probe zur Blindprobe.
Der Viskositätsmessplatz der Fa. Schott besteht aus:

Viskositätsmessplatz AVS 400, Messstativ ASV/S, Glasthermostat, Ubbelohde-Viskosimeter Typ 50110

**Bestimmung des Gelbwertes** (Yellowness Index / Y.I.)

Die Bestimmung des Gelbwertes wurde mit der Minolta Chroma Meter CR-100 an den Prüfkörpern durchgeführt.
Die Bestimmung des Gelbwertes erfolgte gemäß DIN 6167.
Das Gerät wurde grundsätzlich vor jeder Messreihe kalibriert. Nach Auslösen des Messblitzes musste das Display die rückseitig auf der weißen Eichplatte notierten Werte anzeigen:

| | | |
|---|---|---|
| 91,1 | 317 | 335 |
| Y | x | y |

Bei anderen Wertepaaren muss das Gerät nach Herstellerangabe kalibriert werden. Der Referenzgelbwert der Eichplatte beträgt 3,75.
Der Gelbwert errechnet sich folgendermaßen:

$$G(Y.I.) = \frac{(2{,}45 \cdot x - 1{,}149)}{y} + 1{,}149 \cdot 100$$

Zum Messen des Gelbwerts wurde der Prüfkörper so auf die weiße Keramikreferenzplatte gelegt, dass die mittleren Bereiche übereinander liegen. Anschließend wurde der Messblitz ausgelöst.
Die x- und y-Werte wurden abgelesen und nach obiger Formel der Gelbwert (G) ausgerechnet.
Die Ergebnisse sind der nachfolgenden Tabelle zu entnehmen.

**Tabelle**: Ergebnisse

| | | Nullwert | | | nach 500 Stunden | | | nach 1000 Stunden | | | nach 1750 Stunden | | |
|---|---|---|---|---|---|---|---|---|---|---|---|---|---|
| **Beispiel** | **Silan** | **LV** | **Y.I.** | **Delam.** | **LV** | **Y.I.** | **Delam.** | **LV** | **Y.I.** | **Delam.** | **LV** | **Y.I.** | **Delam.** |
| **1 (Vgl.)** | Silquest A-1100, 1 Gew.-% | 1,276 | 3,2 | 0 | n.g. | 6,2 | 0 | 1,087 | 6,1 | 0 | n.g. | 6,2 | 0 |
| **2 (Vgl.)** | Silquest A-137, 0,3 Gew.-% | 1,283 | 2,9 | 66 | 1,258 | 3,8 | 100 | n.g. | n.g. | 100 | n.g. | n.g. | 100 |
| **3 (Vgl.)** | Silquest Y-11597, 0,5 Gew.-% | 1,27 | 6 | 0 | n.g. | n.g. | n.g. | 1,149 | 5,9 | 10 | n.g. | n.g. | n.g. |
| **4 (Erf.)** | Silquest A-1524, 1 Gew.-% | 1,275 | 2,2 | 0 | n.g. | 2,9 | 0 | n.g. | 3,2 | 0 | 1,222 | 3,7 | 0 |

LV: relative Lösungsviskosität
Y.I: yellowness index (Gelbwert "G")
Delam.: delaminierte Oberfläche in % nach Damp Heat Test
n.g.: nicht gemessen

Im Vergleichsbeispiel 1 wurde ein Aminosilan verwendet. Das entsprechende TPU zeigte eine erhebliche, nicht akzeptable Vergilbung.

In den Vergleichsbeispielen 2 und 3 zeigte das Solarmodul im Damp Heat Test Delaminierung.

In dem erfindungsgemäßen Beispiel 4 wurde ein Silan gemäß der Erfindung eingesetzt. Man erhielt einen bewitterungsstabilen, nicht vergilbten und nicht delaminierten Verbund zum Glas.

## Patentansprüche

1. Thermoplastische Polyurethane, erhältlich durch Umsetzung eines Gemisches bestehend aus

   a) einer oder mehreren organischen Diisocyanatkomponenten
   b) mindestens einer Komponente mit einem zahlenmittleren Molekulargewicht von 450 bis 10.000 g/mol und mit im Mittel mindestens 1,8 bis höchstens 3,0 Zerewitinoff-aktiven Wasserstoffatomen,
   c) einem oder mehreren Kettenverlängerern mit einem Molekulargewicht von 60 bis 400 g/mol und mit im Mittel 1,8 bis 3,0 Zerewitinoff-aktiven Wasserstoffatomen,
   wobei das molare Verhältnis der Isocyanatgruppen aus a) zu den gegenüber Isocyanat reaktiven Gruppen aus b), c) und gegebenenfalls h) 0,9:1 bis 1,1:1 beträgt,
   in Gegenwart von
   e) gegebenenfalls Katalysatoren unter Zusatz von
   f) 0,1 bis 10 Gew.-%, bezogen auf thermoplastisches Polyurethan, Lichtstabilisatoren,
   g) gegebenenfalls Zusatzmitteln und/oder Hilfsstoffen,
   h) gegebenenfalls Kettenabbrechern, wobei
   d) 0,05 bis 5 Gew-.%, bezogen auf thermoplastisches Polyurethan, mindestens eines Silans mit der allgemeinen Strukturformel I

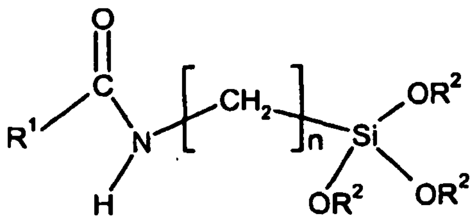

(I)

   n = 1 bis 12 bedeutet $R^1$ = $NHR^3$ mit $R^3$ = H, Alkyl-, Aryl- oder Aralkylgruppe mit 1 bis 20 Kohlenstoffatomen oder $OR^4$ mit $R^4$ = H, Alkyl-, Aryl- oder Aralkylgruppe mit 1 bis 20 Kohlenstoffatomen,
   $R^2$= Alkyl-, Aryl- oder Aralkylgruppe mit 1 bis 20 Kohlenstoffatomen

2. Thermoplastisches Polyurethan gemäß Anspruch 1, wobei die organische Diisocyanatkomponente a) aus ein oder mehreren aliphatischen und/oder cycloaliphatischen Diisocyanaten besteht.

3. Verwendung des thermoplastischen Polyurethans gemäß Anspruch 1 zur Herstellung eines Verbundes mit Glas.

4. Verwendung des thermoplastischen Polyurethans gemäß Anspruch 1 zur Herstellung von Solarzellenmodulen.

## Claims

1. Thermoplastic polyurethanes obtainable by reacting a mixture consisting of

   a) one or more organic diisocyanate components,
   b) at least one component having a number-average molecular weight of 450 to 10 000 g/mol and having on average at least 1.8 to at most 3.0 Zerewitinoff-active hydrogen atoms,
   c) one or more chain extenders having a molecular weight of 60 to 400 g/mol and having an average 1.8 to 3.0 Zerewitinoff-active hydrogen atoms,

the molar ratio of the isocyanate groups from a) to the isocyanate-reactive groups from b), c) and optionally h) being 0.9:1 to 1.1:1,
in the presence of
e) optionally catalysts, with addition of
f) 0.1% to 10% by weight, based on thermoplastic polyurethane, of light stabilizers,
g) optionally adjuvants and/or auxiliaries,
h) optionally chain terminators, with the addition to the thermoplastic polyurethane of
d) 0.05% to 5% by weight, based on thermoplastic polyurethane, of at least one silane having the general structural formula I

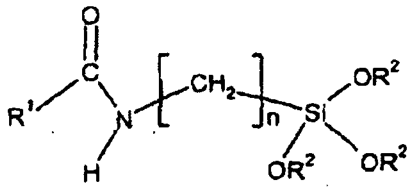

(I)

n = 1 to 12
$R^1$ = $NHR^3$ with $R^3$ = H, alkyl, aryl or aralkyl group having 1 to 20 carbon atoms or $OR^4$ with $R^4$ = H, alkyl, aryl or aralkyl group having 1 to 20 carbon atoms,
$R^2$ = alkyl, aryl or aralkyl group having 1 to 20 carbon atoms
during the preparation of the thermoplastic polyurethane or in an additional process step or during compounding or during extrusion.

**2.** Thermoplastic polyurethane according to Claim 1, the organic diisocyanate component a) being composed of one or more aliphatic and/or cycloaliphatic diisocyanates.

**3.** Use of the thermoplastic polyurethane according to Claim 1 for producing an assembly with glass.

**4.** Use of the thermoplastic polyurethane according to Claim 1 for producing solar cell modules.

## Revendications

**1.** Polyuréthanes thermoplastiques, pouvant être obtenus par réaction d'un mélange constitué par

a) un ou plusieurs composants diisocyanate organiques,
b) au moins un composant ayant un poids moléculaire moyen en nombre de 450 à 10 000 g/mole et contenant en moyenne au moins 1,8 à au plus 3,0 atomes d'hydrogène actifs selon Zerewitinoff,
c) un ou plusieurs allongeurs de chaîne ayant un poids moléculaire de 60 à 400 g/mole et contenant en moyenne 1,8 à 3,0 atomes d'hydrogène actifs selon Zerewitinoff, le rapport molaire entre les groupes isocyanate de a) et les groupes réactifs avec les isocyanates de b), c) et éventuellement h) étant de 0,9:1 à 1,1:1,
en présence de
e) éventuellement des catalyseurs, avec ajout de
f) 0,1 à 10 % en poids, par rapport au polyuréthane thermoplastique, de photostabilisateurs,
g) éventuellement des additifs et/ou des adjuvants,
h) éventuellement des terminateurs de chaînes,
d) 0,05 à 5 % en poids, par rapport au polyuréthane thermoplastique, d'au moins un silane de formule structurale générale I

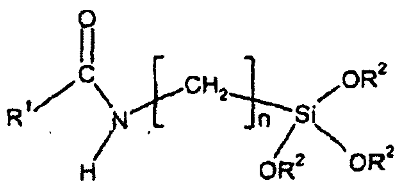

(I)

n = 1 à 12,
$R^1$ = $NHR^3$ avec $R^3$ = H, groupe alkyle, aryle ou aralkyle contenant 1 à 20 atomes de carbone ou $OR^4$ avec $R^4$ = H, groupe alkyle, aryle ou aralkyle contenant 1 à 20 atomes de carbone,
$R^2$ = groupe alkyle, aryle ou aralkyle contenant 1 à 20 atomes de carbone
étant ajouté pendant la fabrication du polyuréthane thermoplastique ou lors d'une étape de procédé supplémentaire ou lors du mélange ou lors de l'extrusion du polyuréthane thermoplastique.

2. Polyuréthane thermoplastique selon la revendication 1, dans lequel le composant diisocyanate organique a) est constitué par un ou plusieurs diisocyanates aliphatiques et/ou cycloaliphatiques.

3. Utilisation du polyuréthane thermoplastique selon la revendication 1 pour la fabrication d'un composite avec du verre.

4. Utilisation du polyuréthane thermoplastique selon la revendication 1 pour la fabrication de modules de cellules solaires.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- GB 1057018 A
- DE 1964834 A
- US 4718956 A
- WO 2004054113 A
- WO 0075213 A
- DE 3101457 A1
- DE 2901774 A


### In der Beschreibung aufgeführte Nicht-Patentliteratur


- Polyurethane. **G. Becker ; D. Braun.** Kunststoff Handbuch. Carl Hanser Verlag, 1983, vol. 7
- **S. Dassin et al.** *Polymer Eng. Sci.,* 2002, vol. 42 (8), 1724-1739
- *Justus Liebigs Annalen der Chemie,* vol. 562, 75-136
- High Polymers. **J.H. Saunders ; K.C. Frisch.** Polyurethane. Verlag Interscience Publishers, 1962, vol. XVI
- **R.Gächter ; u. H.Müller.** Taschenbuch für Kunststoff-Additive. Hanser Verlag, 1990
- **H. Zweifel.** Plastics Additives Handbook. Carl Hanser Verlag, 2001